# EUROPÄISCHE PATENTSCHRIFT

(11) **EP 2 983 214 B1**
(45) Veröffentlichungstag und Bekanntmachung des Hinweises auf die Patenterteilung: **06.03.2019**
(21) Anmeldenummer: 14002778.0
(22) Anmeldetag: 08.08.2014
(51) Int. Cl.: H01L 31/16, H01L 31/167, H02M 3/335, H03K 17/78, H04L 25/26

(54) **Optokoppler**
Optocoupler
Optocoupleur

(43) Veröffentlichungstag der Anmeldung: 10.02.2016
(73) Patentinhaber: AZUR SPACE Solar Power GmbH, 74072 Heilbronn (DE)
(72) Erfinder: Guter, Wolfgang, 70190 Stuttgart (DE); Fuhrmann, Daniel, 74074 Heilbronn (DE); Khorenko, Victor, 74196 Neuenstadt a.K. (DE)
(74) Vertreter: Koch Müller Patentanwaltsgesellschaft mbH

(56) Entgegenhaltungen:
- US-A- 4 127 862
- US-A- 4 996 577
- US-A1- 2006 048 811
- US-B1- 8 350 208

## Beschreibung

Die Erfindung betrifft einen Optokoppler.

Optokoppler sind hinlänglich bekannt. Einfache Optokoppler weisen einen Sendebaustein und einen Empfängerbaustein auf, wobei die beiden Bausteine galvanisch getrennt, jedoch optisch gekoppelt sind. Aus der US 4 996 577 A ist ein Optokopplerbaustein bekannt. Ferner sind aus der US 4 127 862 A, der US 2006 048811 A1 und der US 8 350 208 B1 weitere optische Bauelemente bekannt.

Vor diesem Hintergrund besteht die Aufgabe der Erfindung darin, eine Vorrichtung anzugeben, die den Stand der Technik weiterbildet.

Die Aufgabe wird durch einen Optokoppler mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Optokoppler, aufweisend einen Senderbaustein und einen Empfängerbaustein bereitgestellt, wobei der Senderbaustein und der Empfängerbaustein von einander galvanisch getrennt und optisch gekoppelt sind und die beiden Bausteine in einem gemeinsam Gehäuse integriert sind, und der Empfängerbaustein eine Spannungsquelle umfasst, wobei die Spannungsquelle eine Anzahl N zueinander in Serie geschalteten Teilspannungsquellen aufweist und die Abweisung der Teilquellenspannungen der Teilspannungsquelle zueinander kleiner als 20% ist und jede der Teilspannungsquellen eine Halbleiterdiode mit einen p-n Übergang aufweist, und zwischen jeweils zwei aufeinanderfolgenden Teilspannungsquellen eine Tunneldiode ausgebildet ist, wobei die Teilspannungsquellen und die Tunneldioden zusammen monolithisch integriert sind und gemeinsam einen ersten Stapel mit einer Oberseite und einer Unterseite ausbilden.

Es versteht sich, dass der erste Stapel als Teil des Empfängerbausteins mit einem Photonenstrom aus dem Senderbaustein bestrahlt ist und hierdurch die Quellenspannung erzeugt. Unterliegt die Photonenemission in dem Sendebaustein einer Modulation, verursacht die Modulation eine Wechselspannung, anders ausgedrückt die Höhe der Quellenspannung verändert sich mit der Zeit.

Es versteht sich, dass die Anzahl N der aufeinandergestapelten Teilspannungsquellen vorzugsweise unterhalb zehn liegt.

Ein Vorteil der erfindungsgemäßen Vorrichtung ist es, dass durch die Hintereinanderschaltung von einer Vielzahl von Teilspannungsquellen eine monolithisch integrierte Spannungsquelle mit einer Quellenspannung oberhalb von fünf oder mehr Volt einfach herstellen lässt.

Bevorzugt ist, wenn die Anzahl N der Teilspannungsquellen größer gleich drei ist und der erste Stapel bei 300 K eine Quellenspannung von größer als 4 Volt aufweist, sofern der erste Stapel mit einem Photonenstrom mit einer bestimmten Wellenlänge bestrahlt ist.

In einer Weiterbildung weicht die Quellenspannung der einzelnen Teilspannungsquellen untereinander weniger als 10% ab. Hierdurch wird die Einsetzbarkeit als skalierbare Spannungsquelle insbesondere als Referenzspannungsquelle wesentlich verbessert.

In einer anderen Weiterbildung weisen die Halbleiterdioden jeweils das gleiche Halbleitermaterial auf. Erfindungsgemäß ist der erste Stapel auf einem Halbleitersubstrat angeordnet, insbesondere auf Silizium und / oder Germanium und / oder ein III-V Material wie beispielsweise GaAs. Es ist bevorzugt, auf der Unterseite des ersten Stapels ein zweiter Spannungsanschluss auszubilden und insbesondere, dass der zweite Spannungsanschluss durch das Substrat ausgebildet ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Erfindungsgemäß bestehen die Halbleiterdioden aus einem III-V Material.

Insbesondere ist es vorteilhaft, wenn die Halbleiterdioden jeweils das gleiche Halbleitermaterial aufweisen.

In einer bevorzugten Ausführungsform ist auf der Oberseite des ersten Stapels ein erster Spannungsanschluss als ein umlaufender Metallkontakt in der Nähe des Randes ausgebildet.

Erfindungsgemäß weist der erste Stapel (ST1) eine Grundfläche kleiner als 2 mm² auf. Des Weiteren ist es bevorzugt, wenn der erste Stapel eine Grundfläche kleiner als 1 mm² aufweist. Untersuchungen haben gezeigt, dass es vorteilhaft ist, die Grundfläche viereckig auszubilden. Vorzugsweise ist die Grundfläche des Stapels quadratisch ausgebildet.

Weitere Untersuchungen haben gezeigt, dass um noch höhere Spannungen zu erzielen es vorteilhaft ist, einen zweiten Stapel auszubilden und die beiden Stapel miteinander in Serie zu verschalten, so dass sich die Quellenspannung des ersten Stapels und die Quellenspannung des zweiten Stapels addieren.

Vorzugsweise sind der erste Stapel und der zweite Stapel nebeneinander auf einem gemeinsamen Träger angeordnet.

In einer Weiterbildung weicht die Quellenspannung des ersten Stapels von der Quellenspannung des zweiten Stapels um weniger als 15 % ab.

Untersuchungen haben gezeigt, dass es vorteilhaft ist, in dem Gehäuse eine Auswerteschaltung zu integrieren und wenn die Spannungsquelle in einer elektrischen Wirkverbindung mit der Auswerteschaltung steht. In einer bevorzugten Ausführung umfasst der Empfängerbaustein einen integrierten Halbleiterspiegel, wobei der Halbleiterspiegel vorzugsweise monolithisch höchst vorzugsweise in jedem Stapel integriert ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine erste erfindungsgemäße Ausführungsform eines Optokopplers mit skalierbaren Spannungsquelle mit einem Stapel,
- Figur 2: eine zweite Ausführungsform eines Optokopplers mit einer skalierbaren Spannungsquelle mit mehreren Stapeln.

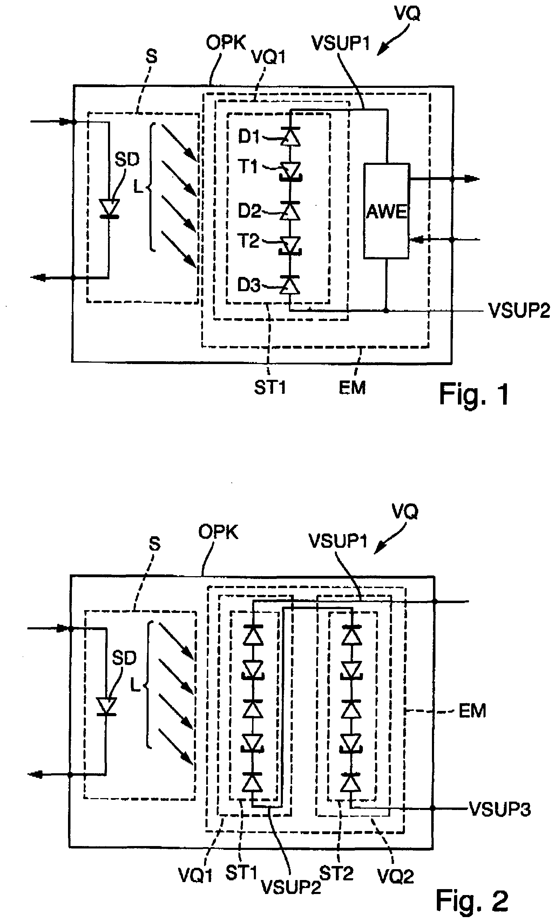

Die Abbildung der Figur 1 zeigt eine schematische Ansicht einer ersten Ausführungsform, aufweisend einen Optokoppler OPK mit einer Sendeeinheit S mit einer Sendediode SD und einer Empfangseinheit EM. Die Empfangseinheit EM weist eine skalierbare Spannungsquelle VQ1 und eine Auswerteeinheit AWE auf. Die Spannungsquelle VQ1 weist einen ersten Stapel ST1 mit einer Oberseite und einer Unterseite mit einer Anzahl N gleich drei Dioden auf. Der erste Stapel ST1 weist eine Serienschaltung aus einer ersten Diode D1 und einer ersten Tunneldiode T1 und einer zweiten Diode D2 und einer zweiten Tunneldiode T2 und einer dritten Diode D3 auf. An der Oberseite des Stapel VQ1 ist ein erster Spannungsanschluss VSUP und der Unterseite des Stapel VQ2 ein zweiter Spannungsanschluss GND ausgebildet. Die Quellenspannung setzt sich vorliegend im Wesentlichen aus den Teilspannungen der einzelnen Diode D1 bis D3 zusammen. Hierzu ist der erste Stapel ST1 einem Photonenstrom L der Sendediode SD ausgesetzt. Sofern die Sendediode SD einen modulierten Photonenstrom aussendet, wird in dem ersten Stapel ST1 die Quellenspannung VQ1 ebenfalls moduliert.

Der erste Stapel ST1 der Dioden D1 bis D3 und den Tunneldioden ist als monolithisch ausgebildeter Block ausgeführt. Die Auswerteeinheit umfasst eine integrierte Schaltung - nicht dargestellt. Der Sendebaustein S und der Empfangsbaustein EM weisen jeweils zwei voneinander galvanisch getrennte Anschlüsse auf.

In der Abbildung der Figur 2 ist eine weitere Ausführungsform des Optokopplers der Figur 1 mit einer vorteilhaften Aneinanderreihung von dem ersten Stapel ST1 und einem zweiten Stapel ST2 ausgebildet. Im Folgenden werden nur die Unterschiede zu der Abbildung der Figur 1 erläutert. Der zweite Stapel ST2 weist aus wie der erste Stapel ST1 eine Serienschaltung aus drei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 sich addieren, sofern die beiden Stapel ST1 und ST2 dem Photonenstrom L der Sendediode SD ausgesetzt sind. Die addierte Quellenspannung liegt nun zwischen dem ersten Spannungsanschluss VSUP1 und einem dritten Spannungsanschluss VSUP3 an. Vorliegend weist der Empfangsbaustein EM keine Auswerteschaltung auf, sodass der erste Spannungsanschluss VSUP und der zweite Spannungsanschluss unmittelbar nach außen geführt sind.

In einer nicht dargestellten Ausführungsform weisen die beiden Stapel ST1 und ST2 zueinander eine unterschiedliche Anzahl von jeweils in einer Serienschaltung verbundenen Dioden auf. In einer anderen nicht dargestellten Ausführungsform sind je Stapel mehr als drei Dioden, vorzugsweise mit einer Anzahl N in einem Bereich zwischen vier und acht Dioden angeordnet. In einer weiteren nicht dargestellten Ausführungsform sind die beiden Stapel zueinander parallel geschaltet.

## Patentansprüche

1. Optokoppler (OPK), aufweisend
einen Senderbaustein (S) und einen Empfängerbaustein (EM), wobei der Senderbaustein (S) und der Empfängerbaustein (EM) von einander galvanisch getrennt und miteinander optisch gekoppelt sind und die beiden Bausteine (S, EM) in einem gemeinsam Gehäuse integriert sind, und
- der Empfängerbaustein (EM) eine Spannungsquelle umfasst, wobei die Spannungsquelle eine Anzahl N zueinander in Serie geschalteten Teilspannungsquellen aufweist und die Abweichung der Teilquellenspannungen der Teilspannungsquelle zueinander kleiner als 20% ist und jede der Teilspannungsquellen eine Halbleiterdiode (D1, D2, D3) mit einen p-n Übergang aufweist,
**dadurch gekennzeichnet, dass**
- zwischen jeweils zwei aufeinanderfolgenden Teilspannungsquellen eine Tunneldiode (T1, T2) ausgebildet ist, wobei
- die Teilspannungsquellen und die Tunneldioden (T1, T2) zusammen monolithisch integriert sind, und gemeinsam einen ersten Stapel (ST1) mit einer Oberseite und einer Unterseite ausbilden, und
die Halbleiterdioden (D1, D2, D3) aus einem III-V Material bestehen, und der erste Stapel auf einem Substrat angeordnet ist und das Substrat ein Halbleitermaterial umfasst, und
der erste Stapel (ST1) eine Grundfläche kleiner als 2 mm² aufweist.

2. Optokoppler (OPK) nach Anspruch 1, **dadurch gekennzeichnet, dass** die und die Anzahl N der Teilspannungsquellen größer gleich drei ist und bei 300 K der erste Stapel (ST1) eine Quellenspannung (VQ1) von größer als 4 Volt aufweist, sofern der erste Stapel (ST1) mit einem Photonenstrom (L) mit einer bestimmten Wellenlänge bestrahlt ist.

3. Optokoppler (OPK) nach Anspruch 1 oder Anspruch 2, **dadurch gekennzeichnet, dass** und die Halbleiterdioden jeweils das gleiche Halbleitermaterial aufweisen.

4. Optokoppler (OPK) nach Anspruch 1 oder Anspruch 2, **dadurch gekennzeichnet, dass** die Quellenspannung der einzelnen Teilspannungsquellen zueinander einer Abweichung kleiner als 10% aufweisen.

5. Optokoppler (OPK) nach einem der Ansprüche 1 bis 4, **dadurch gekennzeichnet, dass** das Halbleitermaterial Germanium umfasst.

6. Optokoppler (OPK) nach einem der vorangegangenen Ansprüche, **dadurch gekennzeichnet, dass** der erste Stapel (ST1) eine Grundfläche kleiner als 1 mm² aufweist.

7. Optokoppler (OPK) nach Anspruch 6, **dadurch gekennzeichnet, dass** die Grundfläche viereckig ausgebildet ist.

8. Optokoppler (OPK) nach einem der vorangegangenen Ansprüche, **dadurch gekennzeichnet, dass** auf der Oberseite des ersten Stapels (ST1) ein erster Spannungsanschluss (VSUP) als ein umlaufender Metallkontakt in der Nähe des Randes ausgebildet ist.

9. Optokoppler (OPK) nach einem der vorangegangenen Ansprüche, **dadurch gekennzeichnet, dass** auf der Unterseite des ersten Stapels (ST1) ein zweiter Spannungsanschluss (VSUP2) ausgebildet ist und der zweite Spannungsanschluss (VSUP2) durch das Substrat ausgebildet ist.

10. Optokoppler (OPK) nach einem der vorangegangenen Ansprüche, **dadurch gekennzeichnet, dass** ein zweiter Stapel (ST2) ausgebildet ist und der erste Stapel (ST1) und der zweite Stapel (ST2) nebeneinander auf einem gemeinsamen Träger angeordnet sind und die beiden Stapel (ST1, ST2) miteinander in Serie verschaltet sind, so dass sich die Quellenspannung (VQ1) des ersten Stapels (ST1) und die Quellenspannung (VQ2) des zweiten Stapels (ST2) addieren.

11. Optokoppler (OPK) nach Anspruch 10, **dadurch gekennzeichnet, dass** die Quellenspannung (VQ1) des ersten Stapel (ST1) von der Quellenspannung (VQ2) des zweiten Stapels (ST2) um weniger als 15 % abweicht.

12. Optokoppler (OPK) nach einem der vorangegangenen Ansprüche, **dadurch gekennzeichnet, dass** in dem Gehäuse eine Auswerteschaltung (AWE) integriert ist und die Spannungsquelle in einer elektrischen Wirkverbindung mit der Auswerteschaltung (AWE) steht.

13. Optokoppler (OPK) nach einem der vorangegangenen Ansprüche, **dadurch gekennzeichnet, dass** der Empfängerbaustein (EM) einen integrierten Halbleiterspiegel umfasst.

## Claims

1. Optocoupler (OPK) comprising
a transmitter block (S) and a receiver block (EM), wherein the transmitter block (S) and the receiver block (EM) are electrically separated from one another and optically coupled together and the two blocks (S, EM) are integrated in a common housing, and
- the receiver block (EM) comprises a voltage source, wherein the voltage source has a number N of voltage sub-sources connected in series with one another and the difference of the sub-source voltages of the voltage sub-sources from one another is less than 20% and each of the voltage sub-sources comprises a semiconductor diode (D1, D2, D3) with a p-n transition,
**characterised in that**
- a tunnel diode (T1, T2) is formed between each two successive voltage sub-sources, wherein
- the voltage sub-sources and the tunnel diodes (T1, T2) are monolithically integrated with one another and together form a first stack (ST1) with an upper side and a lower side, the semiconductor diodes (D1, D2, D3) consist of a III-V material, the first stack is arranged on a substrate, the substrate comprises a semiconductor material, and the first stack (ST1) has a base area smaller than 2 mm².

2. Optocoupler (OPK) according to claim 1, **characterised in that** the number N of the voltage sub-sources is equal to or greater than three and at 300 K the first stack (ST1) has a source voltage (VQ1) greater than 4 volts insofar the first stack (ST1) is irradiated with a photon stream (L) with a defined wavelength.

3. Optocoupler (OPK) according to claim 1 or claim 2, **characterised in that** the semiconductor diodes respectively have the same semiconductor material.

4. Optocoupler (OPK) according to claim 1 or claim 2, **characterised in that** the source voltages of the individual voltage sub-sources have a difference from one another of less than 10%.

5. Optocoupler (OPK) according to any one of claims 1 to 4, **characterised in that** the semiconductor material comprises germanium.

6. Optocoupler (OPK) according to according to any one of the preceding claims, **characterised in that** the first stack (ST1) has a base area smaller than 1 mm².

7. Optocoupler (OPK) according to claim 6, **characterised in that** the base area is four-cornered.

8. Optocoupler (OPK) according to according to any one of the preceding claims, **characterised in that** a first voltage connection (VSUP) is formed on the upper side of the first stack (ST1) as an encircling metal contact in the vicinity of the edge.

9. Optocoupler (OPK) according to according to any one of the preceding claims, **characterised in that** a second voltage connection (VSUP2) is formed on the lower side of the first stack (ST1) and the second voltage connection (VSUP2) is formed by the substrate.

10. Optocoupler (OPK) according to according to any one of the preceding claims, **characterised in that** a second stack (ST2) is formed and the first stack (ST1) and the second stack (ST2) are arranged adjacent to one another on a common support and the two stacks (ST1, ST2) are connected together in series so that the source voltage (VQ1) of the first stack (ST1) and the source voltage (VQ2) of the second stack (ST2) summate.

11. Optocoupler (OPK) according to according to claim 10, **characterised in that** that source voltage (VQ1) of the first stack (ST1) differs from the source voltage (VQ2) of the second stack (ST2) by less than 15%.

12. Optocoupler (OPK) according to according to any one of the preceding claims, **characterised in that** an evaluating circuit (AWE) is integrated in the housing and the voltage source is in electrically operative connection with the evaluating circuit (AWE).

13. Optocoupler (OPK) according to according to any one of the preceding claims, **characterised in that** the receiver block (EM) comprises an integrated semiconductor mirror.

## Revendications

1. Optocoupleur (OPK), présentant
un ensemble émetteur (S) et un ensemble récepteur (EM), dans lequel l'ensemble émetteur (S) et l'ensemble récepteur (EM) sont électriquement séparés l'un de l'autre et sont optiquement couplés l'un à l'autre et les deux ensembles (S, EM) sont intégrés dans un boîtier commun, et
- l'ensemble récepteur (EM) comprend une source de tension, dans lequel la source de tension présente un nombre N de sources de tension partielles connectées en série et l'écart des tensions de sources partielles de la source de tension partielle l'une par rapport à l'autre est inférieur à 20 % et chacune des sources de tension partielles présente une diode à semi-conducteur (D1, D2, D3) avec une transition p-n,
**caractérisé en ce que**
- une diode tunnel (T1, T2) est chaque fois formée entre deux sources de tension partielles successives, dans lequel
- les sources de tension partielles et les diodes tunnel (T1, T2) sont intégrées ensemble de façon monolithique, et forment en commun un premier empilement (ST1) avec un côté supérieur et un côté inférieur, et
les diodes à semi-conducteur (D1, D2, D3) se composent d'un matériau III-V, et
le premier empilement est disposé sur un substrat et le substrat comprend un matériau semi-conducteur, et
le premier empilement (ST1) présente une face de base de moins de 2 mm².

2. Optocoupleur (OPK) selon la revendication 1, **caractérisé en ce que** le nombre N des sources de tension partielles est supérieur ou égal à trois et à 300 K le premier empilement (ST1) présente une tension de source (VQ1) de plus de 4 volts, dans la mesure où le premier empilement (ST1) est irradié avec un flux de photons (L) d'une longueur d'onde déterminée.

3. Optocoupleur (OPK) selon la revendication 1 ou la revendication 2, **caractérisé en ce que** les diodes à semi-conducteur présentent respectivement le même matériau semi-conducteur.

4. Optocoupleur (OPK) selon la revendication 1 ou la revendication 2, **caractérisé en ce que** la tension de source des sources de tension partielles individuelles présente, l'une par rapport à l'autre, un écart inférieur à 10 %.

5. Optocoupleur (OPK) selon l'une quelconque des revendications 1 à 4, **caractérisé en ce que** le matériau semi-conducteur comprend du germanium.

6. Optocoupleur (OPK) selon l'une quelconque des revendications précédentes, **caractérisé en ce que** le premier empilement (ST1) présente une face de base inférieure à 1 mm².

7. Optocoupleur (OPK) selon la revendication 6, **caractérisé en ce que** la face de base est de forme quadrangulaire.

8. Optocoupleur (OPK) selon l'une quelconque des revendications précédentes, **caractérisé en ce qu'**un premier raccord de tension (VSUP) est formé sur le côté supérieur du premier empilement (ST1) sous la forme d'un contact métallique périphérique à proximité du bord.

9. Optocoupleur (OPK) selon l'une quelconque des revendications précédentes, **caractérisé en ce qu'**un second raccord de tension (VSUP2) est formé sur le côté inférieur du premier empilement (ST1) et le second raccord de tension (VSUP2) est formé par le substrat.

10. Optocoupleur (OPK) selon l'une quelconque des revendications précédentes, **caractérisé en ce qu'**un second empilement (ST2) est formé et le premier empilement (ST1) et le second empilement (ST2) sont disposés l'un à côté de l'autre sur un support commun et les deux empilements (ST1, ST2) sont connectés en série l'un à l'autre, de telle manière que la tension de source (VQ1) du premier empilement (ST1) et la tension de source (VQ2) du second empilement (ST2) s'additionnent.

11. Optocoupleur (OPK) selon la revendication 10, **caractérisé en ce que** la tension de source (VQ1) du premier empilement (ST1) diffère de la tension de source (VQ2) du second empilement (ST2) de moins de 15%.

12. Optocoupleur (OPK) selon l'une quelconque des revendications précédentes, **caractérisé en ce qu'**un circuit d'évaluation (AWE) est intégré dans le boîtier et la source de tension se trouve en liaison électrique active avec le circuit d'évaluation (AWE).

13. Optocoupleur (OPK) selon l'une quelconque des revendications précédentes, **caractérisé en ce que** l'ensemble récepteur (EM) comprend un miroir semi-conducteur intégré.
